# EUROPEAN PATENT SPECIFICATION

(11) **EP 2 373 487 B1**
(45) Date of publication and mention of the grant of the patent: **16.07.2014**
(21) Application number: 09774785.1
(22) Date of filing: 03.12.2009
(51) Int. Cl.: B32B 27/00

(54) **METHOD FOR EDGE SEALING BARRIER FILMS**
VERFAHREN ZUR RANDVERSIEGELUNG VON SPERRFILMEN
PROCÉDÉ DE SCELLEMENT ÉTANCHE DE BORDS DE FILMS BARRIÈRES

(30) Priority: 30.12.2008 US 345787
(43) Date of publication of application: 12.10.2011
(60) Divisional application: 12165686.2
(73) Proprietor: Samsung Display Co., Ltd., Yongin-City, Gyeonggi-Do (KR)
(72) Inventor: CHU, Xi, Fremont, CA 94538 (US); BURROWS, Paul, E., Seoul 137-875 (KR); MAST, Eric, S., Richland, WA 99352 (US); MARTIN, Peter, M., Kennewick, WA 99338 (US); GRAFF, Gordon, L., West Richland, WA 99353 (US); GROSS, Mark, E., Pasco, WA 99301 (US); BONHAM, Charles, C., Richland, WA 99352 (US); BENNETT, Wendy, D., Kennewick, WA 99337 (US); ROSENBLUM, Martin, Philip, Menlo Park, CA 94025 (US)
(74) Representative: Mounteney, Simon James
(86) International application number: PCT/US2009/066518
(87) International publication number: WO 2010/077544

(56) References cited:
- EP-A- 0 611 037
- EP-A- 1 719 808
- EP-A- 1 857 270
- WO-A-99/33651
- WO-A-02/051626
- WO-A-2006/093898
- DE-A1-102004 063 619

## Description

The invention relates generally to multilayer, thin film barrier composites for encapsulating environmentally sensitive devices, and more particularly, to multilayer, thin film barrier composites having the edges sealed against lateral moisture and gas diffusion for encapsulating environmentally sensitive devices.

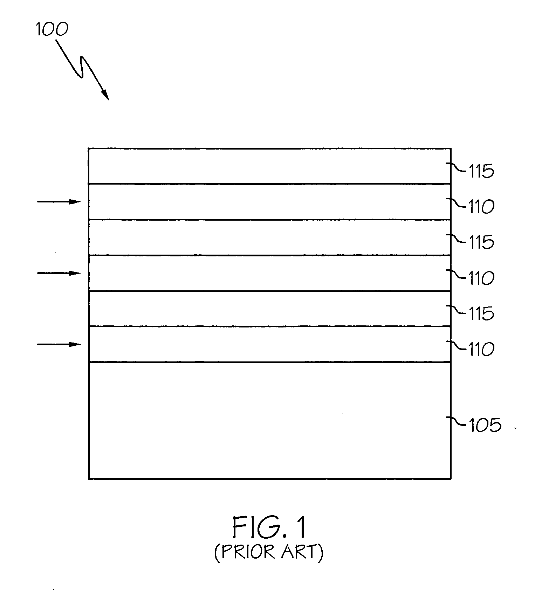

Multilayer, thin film barrier composites having alternating layers of barrier material and polymer material are known. These composites are typically formed by depositing alternating layers of barrier material and polymer material, such as by vapor deposition. If the polymer layers are deposited over the entire surface of the substrate, then the edges of the polymer layers are exposed to oxygen, moisture, and other contaminants. This potentially allows the moisture, oxygen, or other contaminants to diffuse laterally into an encapsulated environmentally sensitive device from the edge of the composite, as shown in FIG. 1. The multilayer, thin film barrier composite 100 includes a substrate 105 and alternating layers of decoupling material 110 and barrier material 115. The scale of FIG. 1 is greatly expanded in the vertical direction. The area of the substrate 105 will typically vary from a few square centimeters to several square meters. The barrier layers 115 are typically a few hundred Angstroms thick, while the decoupling layers 110 are generally less than ten microns thick. The lateral diffusion rate of moisture and oxygen is finite, and this will eventually compromise the encapsulation. One way to reduce the problem of edge diffusion is to provide long edge diffusion paths. However, this decreases the area of the substrate which is usable for active environmentally sensitive devices. In addition, it only lessens the problem, but does not eliminate it.

A similar edge diffusion problem will arise when a substrate containing a multilayer, thin film barrier composite is scribed and separated to create individual components.

Thus, there is a need for an edge-sealed barrier film composite for encapsulating environmentally sensitive devices, and for a method of making such a composite.

The present invention solves this need by providing a method of making an edge-sealed, encapsulated environmentally sensitive device. The method includes providing an environmentally sensitive device with a contact on a substrate; depositing a decoupling layer adjacent to the environmentally sensitive device, the decoupling layer having a discrete area and covering the environmentally sensitive device and not covering the contact, the decoupling layer deposited using a printing process; depositing a first barrier layer adjacent to the decoupling layer, the first barrier layer having a first area greater than the discrete area of the decoupling layer covering the decoupling layer, the first barrier layer having a second area covering the contact, the decoupling layer being sealed between the edges of the first barrier layer and the substrate or an optional second barrier layer; and removing the second area of the first barrier layer from the contact wherein the environmentally sensitive device is selected from the group consisting of organic light emitting devices, liquid crystal displays, displays using electrophoretic inks, light emitting diodes, light emitting polymers, electroluminescent devices, phosphorescent devices, organic photovoltaic devices, inorganic photovoltaic devices, thin film batteries, and thin film devices with vias, microelectromechanical systems (MEMS), Electro-Optic Polymer Modulators, and combinations thereof.

By adjacent, we mean next to, but not necessarily directly next to. There can be additional layers intervening between the substrate and the barrier stacks, and between the barrier stacks and the environmentally sensitive device, etc.
FIG. 1 is a cross-section of a barrier composite of the prior art.
FIG. 2 is a cross-section of one embodiment of an edge-sealed, encapsulated environmentally sensitive device of the present invention.
FIG. 3 shows a successful barrier layer without a seal after 750 hours at 60°C. and 90% relative humidity.
FIG. 4 shows a successful edge seal after 750 hours at 60°C. and 90% relative humidity.
FIG. 5 shows a failed edge seal after 750 hours at 60°C. and 90% relative humidity.
FIG. 6 shows a cross-section of one embodiment of a substrate and mask arrangement and a plan view of the resulting seal.
FIG. 7 shows a cross-section of another embodiment of a substrate and mask arrangement and a plan view of the resulting seal.
FIG. 8 shows a cross-section of one embodiment of an edge-sealed, encapsulated environmentally sensitive device made according to the present invention.
FIG. 9 is a schematic showing an environmentally sensitive device with a contact on a substrate.
FIG. 10 is a schematic showing a barrier layer covering the environmentally sensitive device and contact.
FIG. 11 is a schematic showing a decoupling layer covering the environmentally sensitive device.
FIG. 12 is a schematic showing a hardcoat layer covering the environmentally sensitive device but not the contact.
FIG. 13 is a schematic showing a release layer deposited on the contacts.

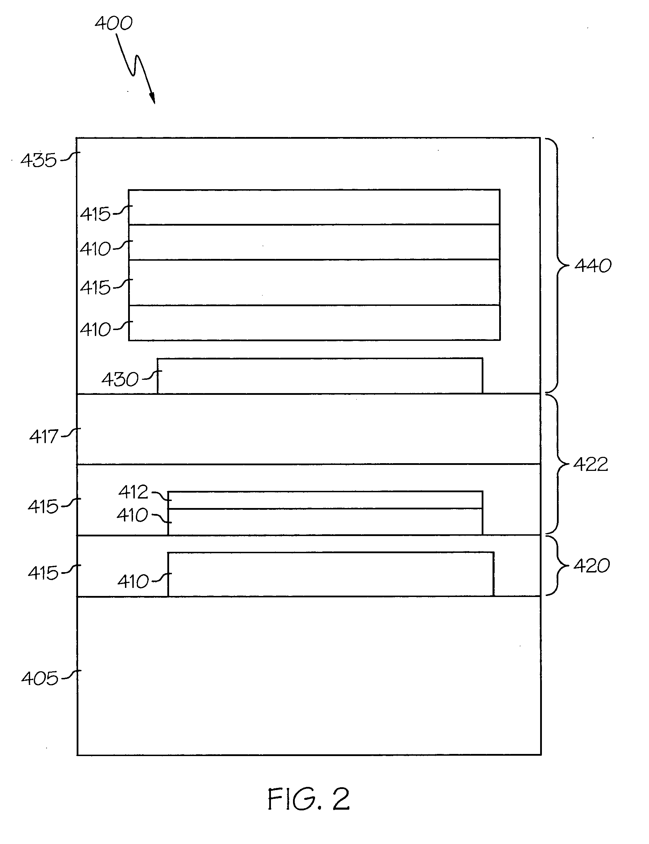

FIG. 2 shows an edge-sealed, encapsulated environmentally sensitive device 400. There is a substrate 405 which can be removed after the device is made, if desired. The environmentally sensitive device 430 is encapsulated between initial barrier stack 422 on one side and additional barrier stack 440 on the other side. There is another initial barrier stack 420 between the substrate 405 and initial barrier stack 422.

The substrate, which is optional, can be any suitable substrate, and can be either rigid or flexible. Suitable substrates include, but are not limited to: polymers, for example, polyethylene terephthalate (PET), polyethylene naphthalate (PEN), or high temperature polymers, such as polyether sulfone (PES), polyimides, or Transphan™ (a high glass transition temperature cyclic olefin polymer available from Lofo High Tech Film, GMBH of Weil am Rhein, Germany) (including polymers with barrier stacks thereon); metals and metal foils; paper; fabric; glass, including thin, flexible, glass sheet (for example, flexible glass sheet available from Corning Inc. under the glass code 0211. This particular thin, flexible glass sheet has a thickness of less than 0.6 mm and will bend at a radium of about 8 inches.); ceramics; semiconductors; silicon; and combinations thereof.

Barrier stack 420 has a barrier layer 415 which has an area greater than the area of the decoupling layer 410 which seals the decoupling layer 410 within the area of the barrier layer 415. Barrier stack 422 has two barrier layers 415, 417 and two decoupling layers 410, 412. Barrier layer 415 has an area greater than that of the decoupling layers 410, 412 which seals the decoupling layers 410, 412 within the area of the barrier layer 415. There is a second barrier layer 417. Because the decoupling layers 410, 412 are sealed within the area covered by the barrier layer 415, ambient moisture, oxygen, and other contaminants cannot diffuse through the decoupling layers to the environmentally sensitive device.

On the other side of the environmentally sensitive device 430, there is an additional barrier stack 440. Barrier stack 440 includes two decoupling layers 410 and two barrier layers 415 which may be of approximately the same size. Barrier stack 440 also includes barrier layer 435 which has an area greater than the area of the decoupling layers 410 which seals the decoupling layers 410 within the area of barrier layer 435.

It is not required that all of the barrier layers have an area greater than all of the decoupling layers, but at least one of the barrier layers must have an area greater than at least one of the decoupling layers. If not all of the barrier layers have an area greater than of the decoupling layers, the barrier layers which do have an area greater than the decoupling layers should form a seal around those which do not so that there are no exposed decoupling layers within the barrier composite, although, clearly it is a matter of degree. The fewer the edge areas of decoupling layers exposed, the less the edge diffusion. If some diffusion is acceptable, then a complete barrier is not required.

The barrier stacks of the present invention on polymeric substrates, such as PET, have measured oxygen transmission rate (OTR) and water vapor transmission rate (WVTR) values well below the detection limits of current industrial instrumentation used for permeation measurements (Mocon OxTran 2/20L and Permatran). Table 1 shows the OTR and WVTR values (measured according to ASTM F 1927-98 and ASTM F 1249-90, respectively) measured at Mocon (Minneapolis, MN) for several barrier stacks on 7 mil PET, along with reported values for other materials.

**Table 1**

| **Sample** | **Oxygen Permeation Rate (cc/m²/day)** | | **Water Vapor Permeation (g/m²/day)⁺** | |
|---|---|---|---|---|
| | **23°C** | **38°C** | **23°C** | **38°C** |
| Native 7 mil PET | 7.62 | - | - | - |
| 1-barrier stack | <0.005 | <0.005* | - | 0.46⁺ |
| 1-barrier stack with ITO | <0.005 | <0.005* | - | 0.011⁺ |
| 2-barrier stacks | <0.005 | <0.005* | - | <0.005⁺ |
| 2-barrier stacks with ITO | <0.005 | <0.005* | - | <0.005⁺ |
| 5-barrier stacks | <0.005 | <0.005* | - | <0.005⁺ |
| 5-barrier stacks with ITO | <0.005 | <0.005* | - | <0.005⁺ |
| DuPont film¹ (PET/Si₃N₄ or PEN/Si₃N₄) | 0.3 | - | - | - |
| Polaroid³ | <1.0 | - | - | - |
| PET/Al² | 0.6 | - | 0.17 | - |
| PET/silicon oxide² | 0.7 - 1.5 | - | 0.15 - 0.9 | - |
| Teijin LCD film (HA grade - TN/STN)³ | <2 | - | <5 | - |

| | | | | |
|---|---|---|---|---|
| (*) 38°C, 90% RH, 100% O₂ (+) 38°C, 100% RH 1 - P. F. Carcia, 46^{th} International Symposium of the American Vacuum Society, Oct. 1999 2 - Langowski, H.C., 39th Annual Technical Conference Proceedings, SVC, pp. 398-401 (1996) 3 - Technical Data Sheet | | | | |

As the data in Table 1 shows, the barrier stacks of the present invention provide oxygen and water vapor permeation rates several orders of magnitude better than PET coated with aluminum, silicon oxide, or aluminum oxide. Typical oxygen permeation rates for other barrier coatings range from about 1 to about 0.1 cc/m²/day. The oxygen transmission rate for the barrier stacks of the present invention is less than 0.005 cc/m²/day at 23°C and 0% relative humidity, and at 38°C and 90% relative humidity. The water vapor transmission rate is less than 0.005 g/m²/day at 38°C and 100% relative humidity. The actual transmission rates are lower, but cannot be measured with existing equipment.

In theory, a good edge seal should be no more permeable than the overall barrier layer. This should result in failure at the edges occurring at a rate statistically the same as that observed anywhere else. In practice, the areas closest to the edge show failure first, and the inference is that edge failure is involved.

The Mocon test for the barrier layers requires significant surface area, and cannot be used to test the edge seal directly. A test using a layer of calcium was developed to measure barrier properties. The calcium test is described in Nisato et al., "Thin Film Encapsulation for OLEDs: Evaluation of Multi-layer Barriers using the Ca Test," SID 03 Digest, 2003, p. 550-553, which is incorporated herein by reference. The calcium test can be used to evaluate edge seal performance for both oxygen transmission rate and water vapor transmission rate. An encapsulated device is made, and the edges are observed for degradation in response to permeation by oxygen and water. The determination is qualitative: pass/fail. Failure is noted at the edges, and the failure progresses inwards from the edges over time. An edge seal which passes the calcium test has an oxygen transmission rate for the edge seal of less than 0.005 cc/m²/day at 23°C and 0% relative humidity, and at 38°C and 90% relative humidity. It would also have a water vapor transmission rate of less than 0.005 g/m²/day at 38°C and 100% relative humidity.

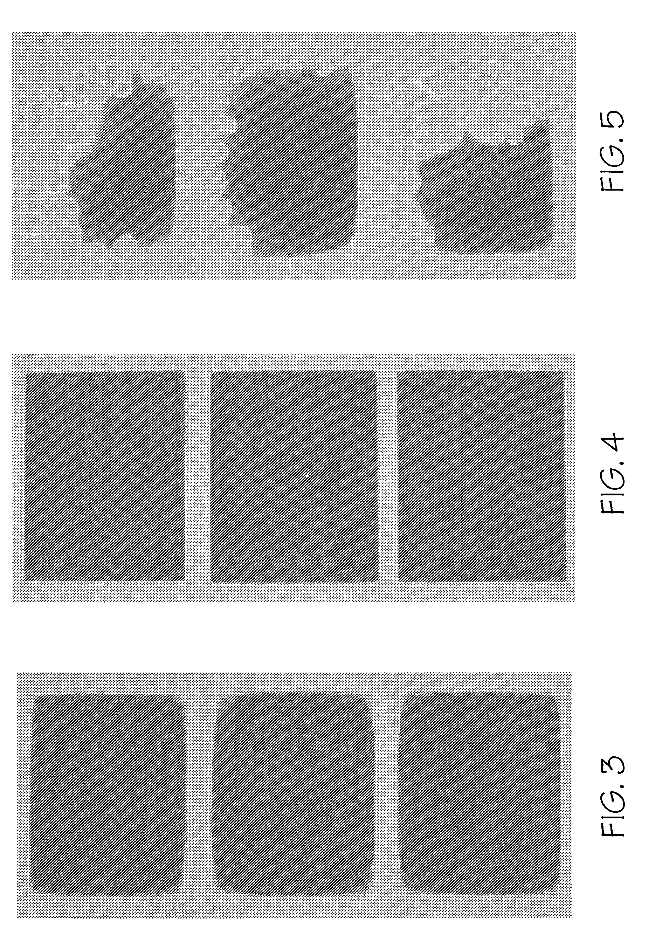

Figs. 3-5 show results from calcium tests after 750 hours at 60°C and 90% relative humidity. Fig. 3 shows a successful barrier layer without a seal. The edge of the barrier layer is more than 50 mm from the calcium edge. Fig. 4 shows a successful edge seal. The edge of the barrier layer is 3 mm from the calcium edge, and no degradation is observed. Fig. 5 shows an edge seal which failed. The edge of the barrier layer is 3 mm from the calcium edge, and severe degradation can be seen.

The number of barrier stacks is not limited. The number of barrier stacks needed depends on the substrate material used and the level of permeation resistance needed for the particular application. One or two barrier stacks may provide sufficient barrier properties for some applications. The most stringent applications may require five or more barrier stacks.

The barrier stacks can have one or more decoupling layers and one or more barrier layers. There could be one decoupling layer and one barrier layer, there could be one or more decoupling layers on one side of one or more barrier layers, there could be one or more decoupling layers on both sides of one or more barrier layers, or there could be one or more barrier layers on both sides of one or more decoupling layers. The important feature is that the barrier stack have at least one decoupling layer and at least one barrier layer. The barrier layers in the barrier stacks can be made of the same material or of a different material, as can the decoupling layers.

The barrier layers are typically about 100 to about 2000 Å thick. The initial barrier layer can be thicker than later barrier layers, if desired. For example, the first barrier layer might be in the range of about 1000 to about 1500 Å, while later barrier layers might be about 400 to about 500 Å. In other situations, the first barrier layer might be thinner than later barrier layers. For example, the first barrier layer might be in the range of about 100 to about 400 Å, while later barrier layers might be about 400 to about 500 Å. The decoupling layers are typically about 0.1 to about 10 µm thick. The first decoupling layer can be thicker than later decoupling layers, if desired. For example, the first decoupling layer might be in the range of about 3 to about 5 µm, while later decoupling layers might be about 0.1 to about 2 µm.

The barrier stacks can have the same or different layers, and the layers can be in the same or different sequences.

If there is only one barrier stack and it has only one decoupling layer and one barrier layer, then the decoupling layer must be first in order for the barrier layer to seal it. The decoupling layer will be sealed between the substrate (or the upper layer of the previous barrier stack) and the barrier layer. Although a device can be made with a single barrier stack having one decoupling layer and one barrier layer on each side of the environmentally sensitive device, there will typically be at least two barrier stacks on each side, each stack having one (or more) decoupling layer and one (or more) barrier layer. In this case, the first layer in the stack can be either a decoupling layer or a barrier layer, as can the last layer.

The barrier layer which seals the decoupling layer may be the first barrier layer in the barrier stack, as shown in barrier stack 420. It may also be a second (or later) barrier layer as shown in barrier stack 440. Barrier layer 435 which seals the barrier stack 440 is the third barrier layer in the barrier stack following two barrier layers 415 which do not seal the barrier stack. Thus, the use of the terms first decoupling layer and first barrier layer in the claims does not refer to the actual sequence of layers, but to layers which meet the limitations. Similarly, the terms first initial barrier stack and first additional barrier stack do not refer to the actual sequence of the initial and additional barrier stacks.

The decoupling layers may be made from the same decoupling material or different decoupling material. The decoupling layer can be made of any suitable decoupling material, including, but not limited to, organic polymers, inorganic polymers, organometallic polymers, hybrid organic/inorganic polymer systems, and combinations thereof. Organic polymers include, but are not limited to, urethanes, polyamides, polyimides, polybutylenes, isobutylene isoprene, polyolefins, epoxies, parylenes, benzocyclobutadiene, polynorbomenes, polyarylethers, polycarbonates, alkyds, polyaniline, ethylene vinyl acetate, ethylene acrylic acid, and combinations thereof. Inorganic polymers include, but are not limited to, silicones, polyphosphazenes, polysilazanes, polycarbosilanes, polycarboranes, carborane siloxanes, polysilanes, phosphonitriles, sulfur nitride polymers, siloxanes, and combinations thereof. Organometallic polymers include, but are not limited to, organometallic polymers of main group metals, transition metals, and lanthanide/actinide metals, or combinations thereof. Hybrid organic/inorganic polymer systems include, but are not limited to, organically modified silicates, preceramic polymers, polyimide-silica hybrids, (meth)acrylate-silica hybrids, polydimethylsiloxane-silica hybrids, and combinations thereof.

The barrier layers may be made from the same barrier material or different barrier material. The barrier layers can be made of any suitable barrier material. Suitable inorganic materials based on metals include, but are not limited to, individual metals, two or more metals as mixtures, inter-metallics or alloys, metal and mixed metal oxides, metal and mixed metal fluorides, metal and mixed metal nitrides, metal and mixed metal carbides, metal and mixed metal carbonitrides, metal and mixed metal oxynitrides, metal and mixed metal borides, metal and mixed metal oxyborides, metal and mixed metal silicides, or combinations thereof. Metals include, but are not limited to, transition ("d" block) metals, lanthanide ("f" block) metals, aluminum, indium, germanium, tin, antimony and bismuth, and combinations thereof. Many of the resultant metal based materials will be conductors or semiconductors. The fluorides and oxides will include dielectrics (insulators), semiconductors and metallic conductors. Non-limiting examples of conductive oxides include aluminum doped zinc oxide, indium tin oxide (ITO), antimony tin oxide, titanium oxides (TiOₓ where 0.8 ≤ x ≤1) and tungsten oxides (WOₓ where 2.7 ≤ x < 3.0). Suitable inorganic materials based on p block semiconductors and non-metals include, but are not limited to, silicon, silicon compounds, boron, boron compounds, carbon compounds including amorphous carbon and diamond-like carbon, and combinations of. Silicon compounds include, but are not limited to silicon oxides (SiOₓ where 1 ≤ x ≤ 2), polysilicic acids, alkali and alkaline earth silicates, aluminosilicates (AlₓSiO_{y}), silicon nitrides (SNₓH_{y} where 0 ≤ y < 1), silicon oxynitrides (SiNₓO_{y}H_{z} where 0 ≤z < 1), silicon carbides (SiCₓH_{y} where 0 ≤ y < 1), and silicon aluminum oxynitrides (SIALONs). Boron compounds include, but are not limited to, boron carbides, boron nitrides, boron oxynitrides, boron carbonitrides, and combinations thereof with silicon.

The barrier layers may be deposited by any suitable process including, but not limited to, conventional vacuum processes such as sputtering, evaporation, sublimation, chemical vapor deposition (CVD), plasma enhanced chemical vapor deposition (PECVD), electron cyclotron resonance-plasma enhanced vapor deposition (ECR-PECVD), and combinations thereof.

The decoupling layer can be produced by a number of known processes which provide improved surface planarity, including both atmospheric processes and vacuum processes. The decoupling layer may be formed by depositing a layer of liquid and subsequently processing the layer of liquid into a solid film. Depositing the decoupling layer as a liquid allows the liquid to flow over the defects in the substrate or previous layer, filling in low areas, and covering up high points, providing a surface with significantly improved planarity. When the decoupling layer is processed into a solid film, the improved surface planarity is retained. Suitable processes for depositing a layer of liquid material and processing it into a solid film include, but are not limited to, vacuum processes and atmospheric processes. Suitable vacuum processes include, but are not limited to, those described in U.S. Patent Nos. 5,260,095, 5,395,644, 5,547,508, 5,691,615, 5,902,641, 5,440,446, and 5,725,909, which are incorporated herein by reference. The liquid spreading apparatus described in 5,260,095, 5,395,644, and 5,547,508 can be further configured to print liquid monomer in discrete, precisely placed regions of the receiving substrate.

Suitable atmospheric processes include, but are not limited to, spin coating, printing, ink jet printing, and/or spraying. By atmospheric processes, we mean processes run at pressures of about 1 atmosphere that can employ the ambient atmosphere. The use of atmospheric processes presents a number of difficulties including the need to cycle between a vacuum environment for depositing the barrier layer and ambient conditions for the decoupling layer, and the exposure of the environmentally sensitive device to environmental contaminants, such as oxygen and moisture. One way to alleviate these problems is to use a specific gas (purge gas) during the atmospheric process to control exposure of the receiving substrate to the environmental contaminants. For example, the process could include cycling between a vacuum environment for barrier layer deposition and an ambient pressure nitrogen environment for the atmospheric process. Printing processes, including ink jet printing, allow the deposition of the decoupling layer in a precise area without the use of masks.

One way to make a decoupling layer involves depositing a polymer precursor, such as a (meth)acrylate containing polymer precursor, and then polymerizing it *in situ* to form the decoupling layer. As used herein, the term polymer precursor means a material which can be polymerized to form a polymer, including, but not limited to, monomers, oligomers, and resins. As another example of a method of making a decoupling layer, a preceramic precursor could be deposited as a liquid by spin coating and then converted to a solid layer. Full thermal conversion is possible for a film of this type directly on a glass or oxide coated substrate. Although it cannot be fully converted to a ceramic at temperatures compatible with some flexible substrates, partial conversion to a cross-lined network structure would be satisfactory. Electron beam techniques could be used to crosslink and/or densify some of these types of polymers and can be combined with thermal techniques to overcome some of the substrate thermal limitations, provided the substrate can handle the electron beam exposure. Another example of making a decoupling layer involves depositing a material, such as a polymer precursor, as a liquid at a temperature above its melting point and subsequently freezing it in place.

One method of making the composite of the present invention includes providing a substrate, and depositing a barrier layer adjacent to the substrate at a barrier deposition station. The substrate with the barrier layer is moved to a decoupling material deposition station. A mask is provided with an opening which limits the deposition of the decoupling layer to an area which is smaller than, and contained within, the area covered by the barrier layer. The first layer deposited could be either the barrier layer or the decoupling layer, depending on the design of the composite.

In order to encapsulate multiple small environmentally sensitive devices contained on a single large motherglass, the decoupling material may be deposited through multiple openings in a single shadow mask, or through multiple shadow masks. Alternatively, the decoupling layer may be deposited in multiple discrete areas by a printing process, e.g., by ink jet printing. The barrier layer may similarly be deposited through multiple openings in a single shadow mask, or through multiple shadow masks. The barrier layer could also be deposited as an overall layer without the use of a mask. Depending on the construction of the environmentally sensitive device, deposition of a barrier layer as an overall layer may also include methods to provide electrical contacts free of the encapsulation, as discussed below. This allows the motherglass to be subsequently diced into individual environmentally sensitive devices, each of which is edge sealed.

For example, the mask may be in the form of a rectangle with the center removed (like a picture frame). The decoupling material is then deposited through the opening in the mask. The layer of decoupling material formed in this way will cover an area less than the area covered by the layer of barrier material. This type of mask can be used in either a batch process or a roll coating process operated in a step and repeat mode. With these processes, all four edges of the decoupling layer will be sealed by the barrier material when a second barrier layer which has an area greater than the area of the decoupling layer is deposited over the decoupling layer.

The method can also be used in a continuous roll to roll process using a mask having two sides which extend inward over the substrate. The opening is formed between the two sides of the mask which allows continuous deposition of decoupling material. The mask may have transverse connections between the two sides so long as they are not in the deposition area for the decoupling layer. The mask is positioned laterally and at a distance from the substrate so as to cause the decoupling material to be deposited over an area less than that of the barrier layer. In this arrangement, the lateral edges of the decoupling layer are sealed by the barrier layer.

The substrate can then be moved to a barrier deposition station (either the original barrier deposition station or a second one), and a second layer of barrier material deposited on the decoupling layer. Since the area covered by the first barrier layer is greater than the area of the decoupling layer, the decoupling layer is sealed between the two barrier layers. These deposition steps can be repeated if necessary until sufficient barrier material is deposited for the particular application.

Alternatively, the decoupling layer may be deposited using a printing process, either as a continuous coating applied in a width less than that covered by a barrier layer, or as multiple discrete areas. Deposition of the decoupling layer in multiple discrete areas allows roll to roll processing to provide a substrate upon which multiple environmentally sensitive devices can be formed (within the confines of the previously deposited decoupling layer). Repetition of these processing steps allows encapsulation of the environmentally sensitive devices in a manner that provides an edge seal around the devices, permitting separation of the devices without compromising the barrier.

When one of the barrier stacks includes two or more decoupling layers, the substrate can be passed by one or more decoupling material deposition stations one or more times before being moved to the barrier deposition station. The decoupling layers can be made from the same decoupling material or different decoupling material. The decoupling layers can be deposited using the same process or using different processes.

Similarly, one or more barrier stacks can include two or more barrier layers. The barrier layers can be formed by passing the substrate (either before or after the decoupling layers have been deposited) past one or more barrier deposition stations one or more times, building up the number of layers desired. The layers can be made of the same or different barrier material, and they can be deposited using the same or different processes.

In another embodiment, the method involves providing a substrate and depositing a layer of barrier material on the surface of the substrate at a barrier deposition station. The substrate with the barrier layer is moved to a decoupling material deposition station where a layer of decoupling material is deposited over substantially the whole surface of the barrier layer. A solid mask is then placed over the substrate with the barrier layer and the decoupling layer. The mask protects the central area of the surface, which would include the areas covered by the active environmentally sensitive devices. A reactive plasma can be used to etch away the edges of the layer of decoupling material outside the mask, which results in the layer of etched decoupling material covering an area less than the area covered by the layer of barrier material. Suitable reactive plasmas include, but are not limited to, O₂, CF₄, and H₂, and combinations thereof. A layer of barrier material covering an area greater than that covered by the etched decoupling layer can then be deposited, sealing the etched decoupling layer between the layers of barrier material.

To ensure good coverage of the edge of the decoupling layer by the barrier layer, techniques for masking and etching the decoupling layer to produce a feathered edge, i.e., a gradual slope instead of a sharp step, may be employed. Several such techniques are known to those in the art, including, but not limited to, standing off the mask a short distance above a polymer surface to be etched.

The deposition and etching steps can be repeated until sufficient barrier material is deposited. This method can be used in a batch process or in a roll coating process operated in a step and repeat mode. In these processes, all four edges of the decoupling layer may be etched. This method can also be used in continuous roll to roll processes. In this case, only the edges of the decoupling material in the direction of the process are etched.

Alternatively, two masks can be used, one for the decoupling material and one for the barrier material. This would allow encapsulation with an edge seal of a device which has electrical contacts which extend outside the encapsulation. The electrical contacts can remain uncoated (or require only minimal post-encapsulation cleaning.) The electrical contacts will typically be thin layer constructions that are sensitive to post-encapsulation cleaning or may be difficult to expose by selective etching of the encapsulation. In addition, if a mask is applied only for the decoupling material, a thick barrier layer could extend over the areas between the devices and cover the contacts. Furthermore, cutting through the thick barrier layer could be difficult.

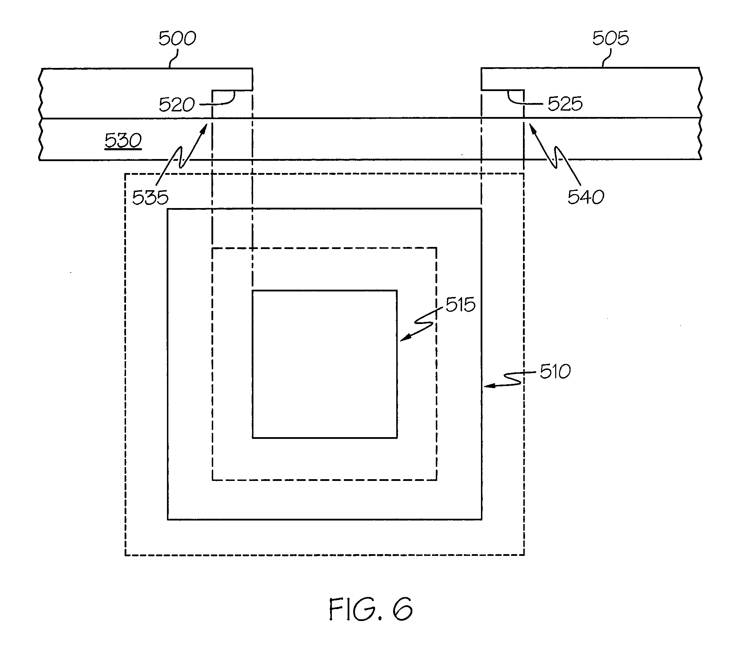

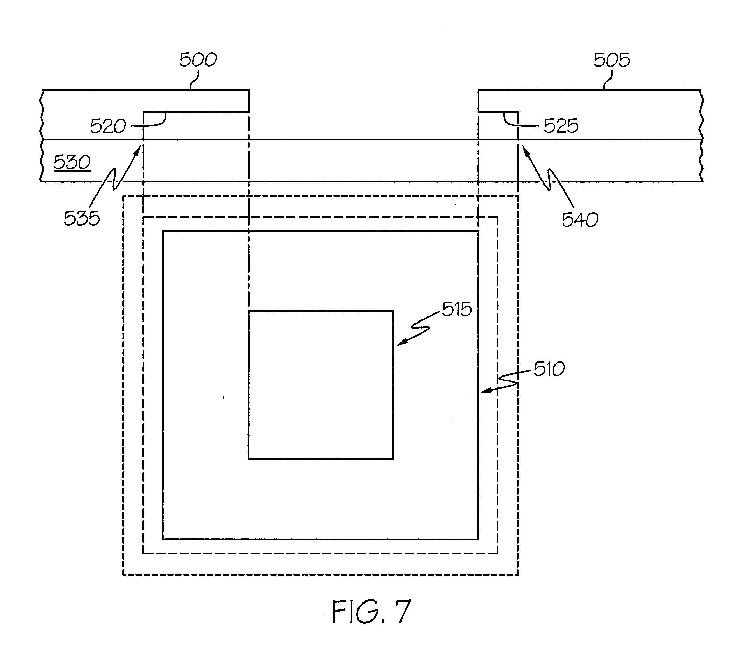

As shown in Figs. 6 and 7, the mask 500 for the decoupling material has a smaller opening than the mask 505 for the barrier material. This allows the barrier layer 510 to encapsulate the decoupling layer 515.

The masks 500, 505 can optionally have an undercut 520, 525 that keeps the deposited decoupling material and/or barrier material from contacting the mask at the point where the mask contacts the substrate 530. The undercut 520 for the decoupling mask 500 can be sufficient to place the decoupling mask contact point 535 outside edge of barrier layer 510, as shown in Fig. 7.

If a composite is made using a continuous process and the edged sealed composite is cut in the transverse direction, the cut edges will expose the edges of the decoupling layers. These cut edges may require additional sealing if the exposure compromises barrier performance.

One method for sealing edges which are to be cut involves depositing a ridge on the substrate before depositing the barrier stack. The ridge interferes with the deposition of the decoupling layer so that the area of barrier material is greater than the area of decoupling material and the decoupling layer is sealed by the barrier layer within the area of barrier material. The ridge should be fairly pointed, for example, triangular shaped, in order to interrupt the deposition and allow the layers of barrier material to extend beyond the layers of decoupling material. The ridge can be deposited anywhere that a cut will need to be made, such as around individual environmentally sensitive devices. The ridge can be made of any suitable material, including, but not limited to, photoresist and barrier materials, such as described previously.

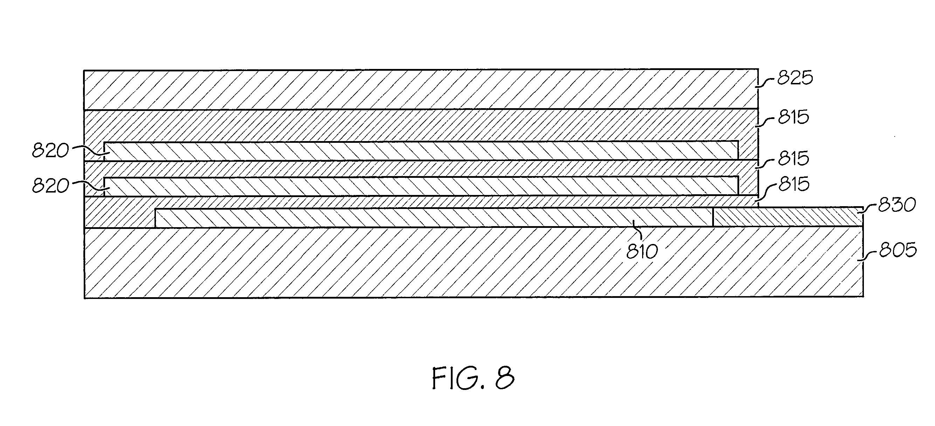

Figs. 8-13 show alternate processes which reduce or eliminate the use of masks. This is desirable because masks must be accurately aligned and frequently cleaned, adding to the cost and complexity of the process. The decoupling layer can be deposited in discrete areas using a printing process, and the barrier layers can be deposited over larger areas either with or without a mask. These methods provide more cost effective ways to create barrier stacks with edge seals. Throughput can also be increased using these methods. They also permit increased flexibility in equipment design.

Fig. 8 shows one embodiment of an encapsulated OLED. There is a substrate 805 with an environmentally sensitive device 810 on it. There is a barrier layer 815 covering the environmentally sensitive device. Decoupling layer 820 covers a portion of the barrier layer 815, followed by a second barrier layer 815 which extends beyond the area covered by the decoupling layer, sealing the decoupling layer 820 between the two barrier layers 815. There is another decoupling layer 820 covering a portion of the second barrier layer 815, followed by a third barrier layer 815 which extends beyond the second decoupling layer 820, sealing it between the second and third barrier layers 815. There is a functional layer 825 on top of the barrier layer 815. There is also a contact 830.

The barrier layers have an area greater than the discrete area of the decoupling layer, and they are in contact with each other outside the discrete area covered by the decoupling layer, forming the seal around the decoupling layer. If the first layer in the stack is a decoupling layer, the seal is formed between the barrier layer and the substrate.

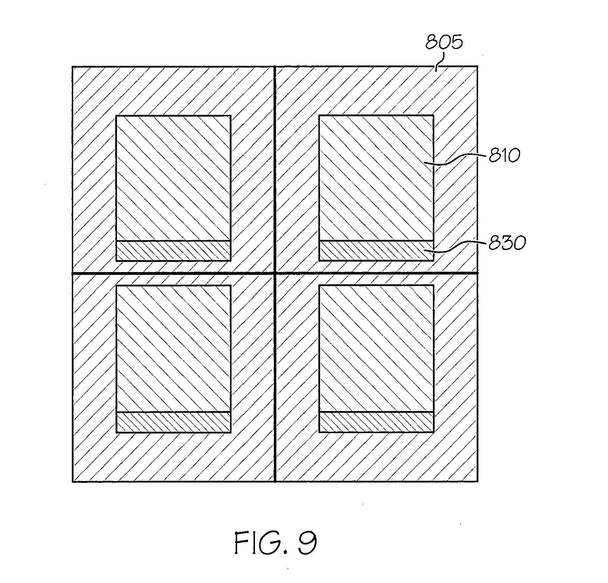

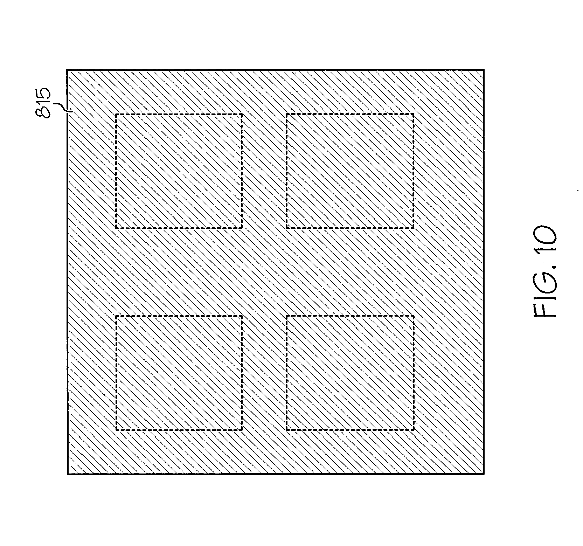

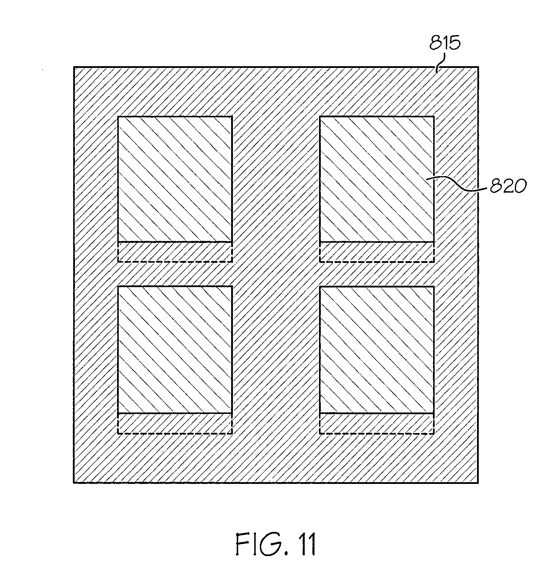

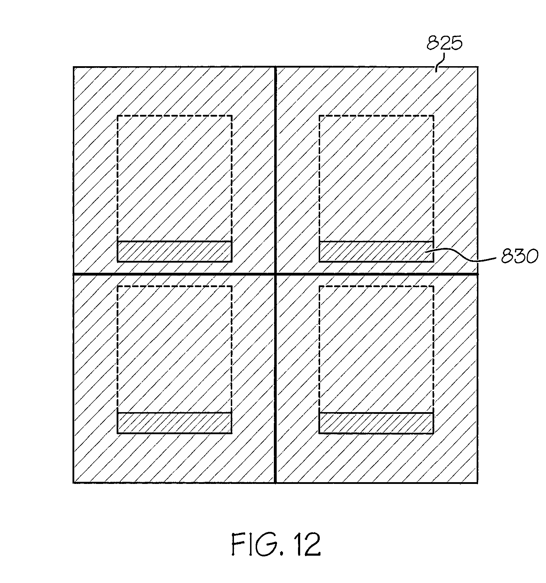

Figs. 9-13 illustrate methods by which the device of Fig. 8 can be produced. As shown in Fig. 9, four environmentally sensitive devices 810 are placed on the substrate 805 and connected to contacts 830. Then a barrier layer 815 is deposited over the entire substrate (Fig. 10). As shown in Fig. 11, the decoupling layer 820 is deposited in discrete areas over the devices, but not over the contacts. The decoupling layer can be deposited in discrete areas by a printing process. Suitable printing processes include, but are not limited to, ink jet printing, screen printing, gravure printing, offset printing, Flexo printing. This would be followed by deposition of a second barrier layer, a second decoupling layer, and a third barrier layer to make the device shown in Fig. 8. A functional layer 825 could then be deposited in a discrete area not covering the contacts (which are covered by three layers of barrier material), as shown in Fig. 12.

One or more functional layers can be included, if desired. Various types of functional layers could be used if desired, including, but not limited to hardcoat layers, photoresist layers, antiglare layers, antireflection layers, impact protective coatings, and antismear/fingerprint coatings, and the like. The functional layer can be deposited in discrete areas, e.g., using a printing process as discussed above. Alternatively, the functional layer can be deposited using processes that cover an overall area, either with or without the use of a mask. If the functional layer is deposited in a discrete area, it would not need to be removed to expose the contacts. For example, the functional layer could be a hardcoat layer which is an etch resistant material. It would then act as an etch mask. Suitable etch resistant hardcoat materials include, but are not limited to, silanes or siloxanes, hexafluorobenzene, pentafluorostyrene, perfluoro-1,3-butadiene or chlorocarbon compounds, and thermoplastic polymer (e.g., mr-I 8000 from micro resist technology GmbH). The three layers of barrier material are then removed to expose the contacts 830. The environmentally sensitive devices can then be separated with each device being protected by the edge sealed barrier layers.

Although the process is show with three barrier layers and two decoupling layers, it is to be understood that the process is not so limited. As discussed above, the number of barrier layers and decoupling layers can vary as needed.

The barrier material can be removed using a variety of processes. Suitable processes include, but are not limited to, a release layer; locally printed etching material; printing a protective layer and either wet etching, dry etching, or sandblasting; lithography and either wet etching, dry etching, or sandblasting; laser ablation; laser ablation combined with a release layer; breaking the substrates and polishing the barrier material; and local mechanical grinding.

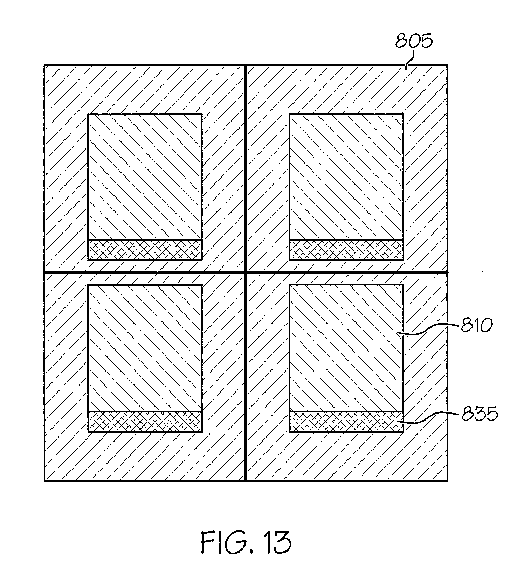

For example, as shown in FIG. 13, a release layer 835 can be deposited on the contacts before the barrier layers are deposited. In that case, after all of the layers have been deposited, the release layer and the barrier layers deposited over it can be removed, exposing the contacts. Suitable release layers include, but are not limited to polytetrafluoroethylene, other fluorinated polymers, polydimethyl siloxane, graphite, MoS2, photodecomposable aryltriazene polymers, and polyimides (e.g., du Pont 5878 (PMDA-ODA) polyimide, for excimer laser).

While certain representative embodiments and details have been shown for purposes of illustrating the invention, it will be apparent to those skilled in the art that various changes in the compositions and methods disclosed herein may be made without departing from the scope of the invention, which is defined in the appended claims.

## Claims

1. A method of making an edge-sealed, encapsulated environmentally sensitive device comprising:
providing an environmentally sensitive device with a contact on a substrate;
depositing a decoupling layer adjacent to the environmentally sensitive device, the decoupling layer having a discrete area and covering the environmentally sensitive device and not covering the contact, the decoupling layer deposited using a printing process;
depositing a first barrier layer adjacent to the decoupling layer, the first barrier layer having a first area greater than the discrete area of the decoupling layer and covering the decoupling layer, the first barrier layer having a second area covering the contact, the decoupling layer being sealed between the edges of the first barrier layer and the substrate or an optional second barrier layer; and
removing the second area of the first barrier layer from the contact wherein the environmentally sensitive device is selected from the group consisting of:
organic light emitting devices, liquid crystal displays, displays using electrophoretic inks, light emitting diodes, light emitting polymers, electroluminescent devices, phosphorescent devices, organic photovoltaic devices, inorganic photovoltaic devices, thin film batteries, thin film devices with vias, microelectromechanical systems (MEMS), electro-optic polymer modulators and combinations thereof.

2. The method of claim 1 wherein the second area of the first barrier layer is removed from the contact by a process selected from wet etching, dry etching, laser ablation, polishing, grinding, or combinations thereof.

3. The method of any of claims 1 - 2 further comprising depositing a release layer on the contact before depositing the decoupling layer and wherein the second area of the barrier layer is removed from the contact by removing the release layer.

4. The method of claim 3 wherein the release layer is made of a material selected from polytetrafluoroethylene, fluorinated polymers, polydimethyl siloxane, graphite, MoS₂, photodecomposable aryltriazene polymers, and polyimides.

5. The method of any of daims 1 - 4 further comprising:
depositing a second barrier layer adjacent to the environmentally sensitive device before depositing the decoupling layer, the second barrier layer having a first area greater than the discrete area of the decoupling layer and covering the decoupling layer, the second barrier layer having a second area covering the contact, the decoupling layer being sealed between the edges of the first and second barrier layers; and
removing the second area of the second barrier layer from the contact.

6. The method of claim 5 further comprising depositing a release layer on the contact before depositing the second barrier layer and wherein the second area of the second barrier layer is removed from the contact by removing the release layer.

7. The method of any of daims 1 - 6 further comprising depositing a functional layer adjacent to the first barrier layer.

8. The method of claim 7 wherein the functional layer is selected from hardcoat layers, photoresist layers, antiglare layers, antireflective layers, impact protective coatings, and antismear/fingerprint coatings.

9. The method of claim 7 wherein the functional layer is a hardcoat layer made of an etch resistant material.

10. The method of claim 9 wherein the etch resistant material is selected from silanes, siloxanes, hexafluorobenzene, pentafluorostyrene, perfluoro-1,3-butadiene, chlorocarbon compounds, and thermoplastic polymers.

11. The method of claim 7 wherein the functional layer is deposited by a printing process selected from ink jet printing, screen printing, gravure printing, offset printing, flexo printing, or combinations thereof.

12. The method of claim 9 wherein the hardcoat layer does not cover the contact.

13. The method of any of claims 1 - 12 further comprising:
depositing a second decoupling layer adjacent to the first barrier layer, the second decoupling layer having a discrete area and covering the environmentally sensitive device and not covering the contact, the second decoupling layer deposited using a printing process; and
depositing a third barrier layer adjacent to the second decoupling layer, the third barrier layer having a first area greater than the discrete area of the second decoupling layer and covering the second decoupling layer, the third barrier layer having a second area covering the contact, the second decoupling layer being sealed between the edges of the first barrier layer and the third barrier layer; and
removing the second area of the third barrier layer.

14. The method of any of daims 1-13 wherein depositing the decoupling layer and depositing the first barrier layer are done in the absence of a mask.

15. The method of any of daims 1-14 wherein there are at least two environmentally sensitive devices on the substrate and further comprising separating the edged sealed environmentally sensitive devices.

16. The method of any of daims 1 -15 wherein the printing process is selected from ink jet printing screen printing, gravure printing, offset printing, flexo printing, or combinations thereof.

17. The product made by the method of claim 1.

## Patentansprüche

1. Verfahren zur Herstellung einer randversiegelten, eingekapselten, gegen Umgebungseinflüsse empfindlichen Vorrichtung, umfassend:
Bereitstellen einer gegen Umgebungseinflüsse empfindlichen Vorrichtung mit einem Kontakt auf einem Substrat;
Aufbringen einer Entkopplungsschicht benachbart zu der gegen Umgebungseinflüsse empfindlichen Vorrichtung, wobei die Entkopplungsschicht einen diskreten Bereich aufweist und die gegen Umgebungseinflüsse empfindliche Vorrichtung abdeckt und den Kontakt nicht abdeckt, wobei die Entkopplungsschicht unter Verwendung eines Druckprozesses aufgebracht wird;
Aufbringen einer ersten Sperrschicht benachbart zur Entkopplungsschicht, wobei die erste Sperrschicht einen ersten Bereich aufweist, der größer als der diskrete Bereich der Entkopplungsschicht ist und die Entkopplungsschicht abdeckt, die erste Sperrschicht einen zweiten Bereich aufweist, der den Kontakt abdeckt, die Entkopplungsschicht zwischen den Rändern der ersten Sperrschicht und dem Substrat oder einer optionalen zweiten Sperrschicht versiegelt wird; und
Entfernen des zweiten Bereichs der ersten Sperrschicht vom Kontakt, wobei die gegen Umgebungseinflüsse empfindliche Vorrichtung aus der Gruppe ausgewählt ist, die aus Folgendem besteht:
organischen Licht emittierenden Vorrichtungen, Flüssigkristallanzeigen, Anzeigen, welche elektrophoretische Tinten verwenden, Leuchtdioden, Licht emittierenden Polymeren, Elektrolumineszenzvorrichtungen, phosphoreszierenden Vorrichtungen, organischen photovoltaischen Vorrichtungen, anorganischen photovoltaischen Vorrichtungen, Dünnfilmbatterien, Dünnfilmvorrichtungen mit Kontaktlöchern, mikroelektromechanischen Systemen (MEMS), elektrooptischen Polymermodulatoren und Kombinationen davon.

2. Verfahren nach Anspruch 1, wobei der zweite Bereich der ersten Sperrschicht durch einen Prozess, der aus Nassätzen, Trockenätzen, Laserablation, Polieren, Schleifen oder Kombinationen davon ausgewählt ist, vom Kontakt entfernt wird.

3. Verfahren nach einem der Ansprüche 1 bis 2, ferner umfassend ein Aufbringen einer Trennschicht auf den Kontakt vor dem Aufbringen der Entkopplungsschicht, und wobei der zweite Bereich der Sperrschicht durch Entfernen der Trennschicht vom Kontakt entfernt wird.

4. Verfahren nach Anspruch 3, wobei die Trennschicht aus einem Material hergestellt ist, das aus Polytetrafluorethylen, fluorierten Polymeren, Polydimethylsiloxan, Graphit, MoS₂, photozersetzbaren Aryltriazenpolymeren und Polyimiden ausgewählt ist.

5. Verfahren nach einem der Ansprüche 1 bis 4, ferner umfassend:
Aufbringen einer zweiten Sperrschicht benachbart zu der gegen Umgebungseinflüsse empfindlichen Vorrichtung vor dem Aufbringen der Entkopplungsschicht, wobei die zweite Sperrschicht einen ersten Bereich aufweist, der größer als der diskrete Bereich der Entkopplungsschicht ist und die Entkopplungsschicht abdeckt, die zweite Sperrschicht einen zweiten Bereich aufweist, der den Kontakt abdeckt, die Entkopplungsschicht zwischen den Rändern der ersten und zweiten Sperrschichten versiegelt wird; und
Entfernen des zweiten Bereichs der zweiten Sperrschicht vom Kontakt.

6. Verfahren nach Anspruch 5, ferner umfassend ein Aufbringen einer Trennschicht auf den Kontakt vor dem Aufbringen der zweiten Sperrschicht, und wobei der zweite Bereich der zweiten Sperrschicht durch Entfernen der Trennschicht vom Kontakt entfernt wird.

7. Verfahren nach einem der Ansprüche 1 bis 6, ferner umfassend ein Aufbringen einer Funktionsschicht benachbart zur ersten Sperrschicht.

8. Verfahren nach Anspruch 7, wobei die Funktionsschicht aus Hartstoffschichten, Photolackschichten, blendfreien Schichten, Antireflexionsschichten, Aufprallschutzbeschichtungen und Beschichtungen zum Schutz gegen Verschmierung und Fingerabdrücke ausgewählt ist.

9. Verfahren nach Anspruch 7, wobei die Funktionsschicht eine Hartstoffschicht ist, die aus einem ätzbeständigen Material hergestellt ist.

10. Verfahren nach Anspruch 9, wobei das ätzbeständige Material aus Silanen, Siloxanen, Hexafluorbenzen, Pentafluorstyrol, Perfluor-1,3-butadien, Chlorkohlenwasserstoffverbindungen und thermoplastischen Polymeren ausgewählt ist.

11. Verfahren nach Anspruch 7, wobei die Funktionsschicht durch einen Druckprozess aufgebracht wird, der aus Tintenstrahldruck, Siebdruck, Tiefdruck, Offsetdruck, Flexodruck oder Kombinationen davon ausgewählt ist.

12. Verfahren nach Anspruch 9, wobei die Hartstoffschicht den Kontakt nicht abdeckt.

13. Verfahren nach einem der Ansprüche 1 bis 12, ferner umfassend:
Aufbringen einer zweiten Entkopplungsschicht benachbart zur ersten Sperrschicht, wobei die zweite Entkopplungsschicht einen diskreten Bereich aufweist und die gegen Umgebungseinflüsse empfindliche Vorrichtung abdeckt und den Kontakt nicht abdeckt, wobei die zweite Entkopplungsschicht unter Verwendung eines Druckprozesses aufgebracht wird; und
Aufbringen einer dritten Sperrschicht benachbart zur zweiten Entkopplungsschicht, wobei die dritte Sperrschicht einen ersten Bereich aufweist, der größer als der diskrete Bereich der zweiten Entkopplungsschicht ist und die zweite Entkopplungsschicht abdeckt, die dritte Sperrschicht einen zweiten Bereich aufweist, der den Kontakt abdeckt, die zweite Entkopplungsschicht zwischen den Rändern der ersten Sperrschicht und der dritten Sperrschicht versiegelt wird; und
Entfernen des zweiten Bereichs der dritten Sperrschicht vom Kontakt.

14. Verfahren nach einem der Ansprüche 1 bis 13, wobei das Aufbringen der Entkopplungsschicht und Aufbringen der ersten Sperrschicht ohne Vorhandensein einer Maske erfolgen.

15. Verfahren nach einem der Ansprüche 1 bis 14, wobei mindestens zwei gegen Umgebungseinflüsse empfindliche Vorrichtungen auf dem Substrat vorhanden sind, und ferner umfassend ein Trennen der randversiegelten, gegen Umgebungseinflüsse empfindlichen Vorrichtungen.

16. Verfahren nach einem der Ansprüche 1 bis 15, wobei der Druckprozess aus Tintenstrahldruck, Siebdruck, Tiefdruck, Offsetdruck, Flexodruck oder Kombinationen davon ausgewählt ist.

17. Produkt, hergestellt durch das Verfahren nach Anspruch 1.

## Revendications

1. Procédé de réalisation d'un dispositif encapsulé, à bords scellés et sensible à l'environnement, comprenant les étapes consistant à :
fournir un dispositif sensible à l'environnement avec un contact sur un substrat ;
déposer une couche de découplage à côté du dispositif sensible à l'environnement, la couche de découplage présentant une zone distincte et couvrant le dispositif sensible à l'environnement et ne couvrant pas le contact, la couche de découplage étant déposée en utilisant un procédé d'impression ;
déposer une première couche barrière à côté de la couche de découplage, la première couche barrière présentant une première zone qui est plus grande que la zone distincte appartenant à la couche de découplage et qui couvre la couche de découplage, la première couche barrière présentant une seconde zone couvrant le contact, la couche de découplage étant scellée entre les bords de la première couche barrière et le substrat ou une deuxième couche barrière facultative ; et
retirer la seconde zone de la première couche barrière du contact, le dispositif sensible à l'environnement étant sélectionné parmi le groupe constitué de :
dispositifs organiques émetteurs de lumière, affichages à cristaux liquides, affichages utilisant des encres électrophorétiques, diodes électroluminescentes, polymères émetteurs de lumière, dispositifs électroluminescents, dispositifs phosphorescents, dispositifs photovoltaïques organiques, dispositifs photovoltaïques minéraux, batteries à couches minces, dispositifs à couches minces à vias, systèmes microélectromécaniques (MEMS), modulateurs à polymères électro-optiques et des combinaisons de ceux-ci.

2. Procédé selon la revendication 1, dans lequel la seconde zone de la première couche barrière est retirée du contact au moyen d'un procédé sélectionné parmi la gravure humide, la gravure à sec, l'ablation par laser, le polissage, le meulage, ou des combinaisons de ceux-ci.

3. Procédé selon la revendication 1 ou 2, comprenant en outre l'étape consistant à déposer une couche de séparation sur le contact avant de déposer la couche de découplage, la seconde zone de la couche barrière étant retirée du contact lorsqu'on retire la couche de séparation.

4. Procédé selon la revendication 3, dans lequel la couche de séparation est constituée d'un matériau sélectionné parmi polytétrafluoroéthylène, polymères fluorés, polydiméthylsiloxane, graphite, MoS₂, polymères aryltriazène photodécomposables, et polyimides.

5. Procédé selon l'une quelconque des revendications 1 à 4, comprenant en outre les étapes consistant à :
déposer une deuxième couche barrière à côté du dispositif sensible à l'environnement avant de déposer la couche de découplage, la deuxième couche barrière présentant une première zone qui est plus grande que la zone distincte appartenant à la couche de découplage et qui couvre la couche de découplage, la deuxième couche barrière présentant une seconde zone couvrant le contact, la couche de découplage étant scellée entre les bords des première et deuxième couches barrières ; et
retirer du contact la seconde zone de la deuxième couche barrière.

6. Procédé selon la revendication 5, comprenant en outre l'étape consistant à déposer une couche de séparation sur le contact avant de déposer la deuxième couche barrière, la seconde zone de la deuxième couche barrière étant retirée du contact lorsqu'on retire la couche de séparation.

7. Procédé selon l'une quelconque des revendications 1 à 6, comprenant en outre l'étape consistant à déposer une couche fonctionnelle à côté de la première couche barrière.

8. Procédé selon la revendication 7, dans lequel la couche fonctionnelle est sélectionnée parmi des couches dures, des couches photorésistantes, des couches anti-éblouissement, des couches anti-reflet, des revêtements de protection contre les impacts, et des revêtements anti-salissure/anti-trace de doigt.

9. Procédé selon la revendication 7, dans lequel la couche fonctionnelle est une couche dure réalisée en un matériau résistant à la gravure.

10. Procédé selon la revendication 9, dans lequel le matériau résistant à la gravure est sélectionné parmi des silanes, siloxanes, hexafluorobenzène, pentafluorostyrène, perfluoro-1,3-butadiène, composés chlorocarbonés, et polymères thermoplastiques.

11. Procédé selon la revendication 7, dans lequel la couche fonctionnelle est déposée au moyen d'un procédé d'impression sélectionné parmi l'impression jet d'encre, la sérigraphie, l'héliogravure, l'impression offset, l'impression flexo et des combinaisons de celles-ci.

12. Procédé selon la revendication 9, dans lequel la couche dure ne recouvre pas le contact.

13. Procédé selon l'une quelconque des revendications 1 à 12, comprenant en outre les étapes consistant à :
déposer une seconde couche de découplage à côté de la première couche barrière, la seconde couche de découplage présentant une zone distincte et couvrant le dispositif sensible à l'environnement et ne couvrant pas le contact, la seconde couche de découplage étant déposée en utilisant un procédé d'impression ; et
déposer une troisième couche barrière à côté de la seconde couche de découplage, la troisième couche barrière présentant une première zone qui est plus grande que la zone distincte appartenant à la seconde couche de découplage et qui couvre la seconde couche de découplage, la troisième couche barrière présentant une seconde zone couvrant le contact, la seconde couche de découplage étant scellée entre les bords de la première couche barrière et de la troisième couche barrière ; et
retirer la seconde zone de la troisième couche barrière.

14. Procédé selon l'une quelconque des revendications 1 à 13, dans lequel les étapes consistant à déposer la couche de découplage et à déposer la première couche barrière sont réalisées en l'absence d'un masque.

15. Procédé selon l'une quelconque des revendications 1 à 14, dans lequel il existe au moins deux dispositifs sensibles à l'environnement sur le substrat et comprenant en outre l'étape consistant à séparer les dispositifs sensibles à l'environnement à bords scellés.

16. Procédé selon l'une quelconque des revendications 1 à 15, dans lequel le procédé d'impression est sélectionné parmi l'impression jet d'encre, la sérigraphie, l'héliogravure, l'impression offset, l'impression flexo, ou des combinaisons de celles-ci.

17. Produit réalisé au moyen du procédé selon la revendication 1.
